# EUROPEAN PATENT SPECIFICATION

(11) **EP 3 113 314 B1**
(45) Date of publication and mention of the grant of the patent: **01.07.2020**
(21) Application number: 15175243.3
(22) Date of filing: 03.07.2015
(51) Int. Cl.: H02J 50/12, H02J 7/02, H02M 3/338, H02M 7/797, H02M 7/162, H02M 7/516, H02M 7/521, H02M 7/219, H02M 7/48, H02M 7/523, H02M 7/5383, H02M 7/5387, H03B 5/12

(54) **APPARATUS AND METHOD FOR WIRELESS POWER TRANSFER**
VORRICHTUNG UND VERFAHREN ZUR DRAHTLOSEN STROMÜBERTRAGUNG
APPAREIL ET PROCÉDÉ DE TRANSMISSION DE PUISSANCE SANS FIL

(43) Date of publication of application: 04.01.2017
(73) Proprietor: Nokia Technologies Oy, 02610 Espoo (FI)
(72) Inventor: Muurinen, Jari, 25500 Perniö (FI)
(74) Representative: Swindell & Pearson Limited

(56) References cited:
- EP-A2- 1 471 626
- WO-A1-2012/145082
- WO-A1-2014/039088
- WO-A2-2012/010900
- US-A- 4 672 159
- US-A- 5 416 386
- US-A1- 2014 097 791
- US-B1- 8 102 216
- POUYA KAMALINEJAD ET AL: "An efficient CMOS rectifier with low-voltage operation for RFID tags", GREEN COMPUTING CONFERENCE AND WORKSHOPS (IGCC), 2011 INTERNATIONAL, IEEE, 25 July 2011 (2011-07-25), pages 1-6, XP031934316, DOI: 10.1109/IGCC.2011.6008606 ISBN: 978-1-4577-1222-7

## Description

### TECHNOLOGICAL FIELD

Examples of the present disclosure relate to an apparatus and method for wireless power transfer. Some examples, though without prejudice to the foregoing, relate to an apparatus able to provide both wireless power transmission and also wireless power reception.

### BACKGROUND

Electrical power may be wirelessly transferred from a power source to a power consuming device via time-varying magnetic fields thereby avoiding the need for solid wires or conductors to convey electrical power.

Conventional devices for wireless power transfer are not always optimal. Some conventional devices may utilise an array of electrical switches/transistors to provide an alternating current through a coil to generate a wireless power transmission signal, e.g. time varying magnetic field (to be received by a further coil of a receiving device to induce a voltage therein). However, such conventional devices typically require a separate dedicated microcontroller to actively control the operation of the electrical switches/transistors. Also, some conventional wireless power transmission devices are unable to additionally operate in a wireless power reception mode.

US 2014/0097791 discloses an auto-resonant driver for a transmitter inductor which drives the inductor at an optimal frequency for maximum efficiency. The transmitter inductor is magnetically coupled, but not physically coupled, to a receiver inductor, and the current generated by the receiver inductor is used to power a load. The system may be used, for example, to remotely charge a battery (as part of the load) or provide power to motors or circuits. A feedback circuit is used to generate the resonant driving frequency. A detector in the transmit side wirelessly detects whether there is sufficient current being generated in the receiver side to achieve regulation by a voltage regulator powering the load. This point is achieved when the transmitter inductor peak voltage suddenly increases as the driving pulse width is ramped up. At that point, the pulse width is held constant for optimal efficiency.

WO 2014/039088 discloses an invention relating to a wireless power supply system including a remote device capable of both transmitting and receiving power wirelessly. The remote device includes a self-driven synchronous rectifier. The wireless power supply system may also include a wireless power supply configured to enter an OFF state in which no power, or substantially no power, is drawn, and to wake from the OFF state in response to receiving power from a remote device.

EP1471626 discloses a driver circuit for a transistor providing a soft start feature where pulses provided to the transistor are varied in duration during startup. The driver also provides an overcurrent protection feature for disabling a driver output for a safe period of time when an overcurrent condition is detected. The driver circuit includes an oscillator that produces a saw tooth wave and a narrow width pulse train for determining pulse width and dead time, respectively. The driver circuit may be used in half-bridge or full-bridge drivers. WO 2012/010900 discloses a full bridge circuit which comprises a pair of AC terminals and a pair of DC terminals. The full bridge circuit is adapted in a first mode of operation to receive an AC voltage input at its AC terminals and provide a rectified voltage output at its DC terminals. In addition, the full bridge circuit is adapted in a second mode of operation either to receive a DC voltage input at its DC terminals and provide an AC voltage output at its AC terminals, or to receive a DC voltage input at its DC terminals and act as a bidirectional switch across the AC terminals.

US 4,672,159 discloses a power-line-operated electronic inverter-type power supply for the magnetron in a microwave oven. The unfiltered pulsed DC output of a full-wave rectifier is applied to a bridge inverter, the output of which is a 30 kHz squarewave voltage pulse-amplitude-modulated at 120 Hz. By way of a step-up voltage transformer, this 30 kHz output voltage is applied to a high-Q series-resonant L-C circuit. The Q-multiplied voltage developing across the tank capacitor of this L-C circuit is then rectified and filtered for 30 kHz ripple-voltage. The output resulting from this high-frequency rectification is a 120 Hz pulse-amplitude-modulated current-limited DC voltage suitable for direct application to the magnetron. The bridge inverter has to be triggered into oscillation; which oscillation ceases each time the magnitude of the inverter DC supply voltage decreases below a given threshold level. Under normal operation, for each cycle of the 120 Hz pulse-amplitude-modulated DC voltage that constitutes this DC supply voltage, the inverter starts and stops oscillation. Simple control means then permits the starting point of this oscillation to be phase-controlled in fashion similar to the way in which a Triac or an SCR can be phase-controlled. When the inverter power supply is operating under full power, due to the innate characteristics of the magnetron-loaded L-C series-resonant circuit, the power factor of the power drawn from the 60 Hz power line is nearly 100%.

US 5,416,386 discloses a pre-converter that is connected with AC power line voltage and provides DC rail voltage to a current-fed self-oscillating FET bridge inverter ballast. The inverter is loaded by way of a parallel-tuned L-C circuit connected across the bridge inverter's output, thereby providing a sinusoidal AC output voltage thereat. Each of several instant-start fluorescent lamps is connected via a current-limiting capacitor across the bridge inverter's output. The magnitude of the DC supply voltage is so chosen as to cause the magnitude of the AC output voltage to be such as to effectuate proper instant-starting of the fluorescent lamps. Each of the four FET's is driven by a sinusoidal AC voltage derived directly from a positive feedback winding on the tank-inductor of the L-C circuit. To enhance circuit efficiency, the absolute magnitude of the DC rail voltage is controlled to be just higher than the peak absolute magnitude of the AC power line voltage.

Pouya Kamalinejad et al.: "An Efficient CMOS Rectifier with Low-Voltage Operation for RFID Tags", Green Computing Conference and Workshops (IGCC), 2011 International, IEEE 25 July 2011, discloses a high efficiency CMOS rectifier for radio-frequency identification applications. An on-chip generated clock signal is used to provide a switching scheme to enhance the power efficiency of a conventional 4 transistor cell rectifier. By switching the gate of charge-transfer transistors to intermediate nodes of preceding and succeeding stages, low on-resistance and small leakage current are obtained simultaneously. An external gate-boosting technique is also applied to the proposed design which enables an efficient operation for input voltage levels well below the nominal standard threshold of MOS transistors.

WO 2012/145082 discloses an electronic high frequency induction heater driver, for a variable spray fuel injection system, that uses a zero-voltage switching oscillator that utilizes a full H -bridge topology with inductors separating the high or low power supply from the switching devices wherein the semiconductor switches are synchronized within the bridge for function. The induction heater driver, upon receipt of a turn-on signal, multiplies a supply voltage through a self - oscillating series resonance, wherein one component of the tank resonator circuit comprises an induction heater coil magnetically coupled to an appropriate loss component so that fuel inside a fuel component is heated to a desired temperature.

The listing or discussion of any prior-published document or any background in this specification should not necessarily be taken as an acknowledgement that the document or background is part of the state of the art or is common general knowledge. One or more aspects/examples of the present disclosure may or may not address one or more of the background issues.

### BRIEF SUMMARY

The present invention is as set out in the independent claims. Any examples/embodiments and features described in this specification that do not fall under the scope of the independent claims are to be interpreted as examples useful for understanding various embodiments of the invention.

According to various but not necessarily all examples of the disclosure there is provided an apparatus comprising means configured to provide wireless power transmission in a wireless power transmission mode, wherein the means comprises an H bridge circuitry arrangement configured such that, in use during the wireless power transmission mode, the H bridge circuitry arrangement self-oscillates.

According to various but not necessarily all examples of the disclosure there is provided an apparatus configured to provide wireless power transmission in a wireless power transmission mode, wherein the apparatus comprises an H bridge circuitry arrangement configured such that, in use during the wireless power transmission mode, the H bridge circuitry arrangement self-oscillates.

According to various but not necessarily all examples of the disclosure there is provided a method comprising: generating a self-oscillating current in an H bridge circuitry arrangement; and wirelessly transmitting power via the H bridge circuitry arrangement.

According to various but not necessarily all examples of the disclosure there is provided a method comprising:
receiving a wireless power transmission;
inducing a voltage from the received wireless power transmission; and rectifying the induced voltage via an H bridge circuitry arrangement, and
wherein the H bridge circuitry arrangement: is configured such that, in use during the wireless power transmission mode, the H bridge circuitry arrangement self-oscillates.

### BRIEF DESCRIPTION OF THE DRAWINGS

For a better understanding of various examples of the present disclosure that are useful for understanding the detailed description and certain embodiments of the invention, reference will now be made by way of example only to the accompanying drawings in which:
Figure 1 schematically illustrates an apparatus;
Figure 2 is a circuit diagram of a further apparatus for wireless power transmission;
Figure 3 is a circuit diagram of a yet further apparatus for wireless power reception;
Figure 4 is a circuit diagram a yet further apparatus for both wireless power transmission and reception;
Figure 5 schematically illustrates a wireless power transfer system;
Figure 6A schematically illustrates parts of a wireless power transfer system;
Figure 6B illustrates simulated voltage and current measurements of the parts of the wireless power transfer system of Figure 6A;
Figure 7A schematically illustrates further parts of a wireless power transfer system;
Figure 7B illustrates simulated voltage and current measurements of the further parts of the wireless power transfer system of Figure 7A;
Figure 8 schematically illustrates a method for wireless power transmission; and
Figure 9 schematically illustrates a method for wireless power reception.

### DETAILED DESCRIPTION

Examples of apparatuses and methods for wireless power transfer according to the present disclosure will now be described with reference to the Figures. Similar reference numerals are used in the Figures to designate similar features. For clarity, all reference numerals are not necessarily displayed in all figures. The Figures are not necessarily to scale. Certain features and views of the figures may be shown schematically or exaggerated in scale in the interest of clarity and conciseness.

The examples of the present disclosure and the accompanying claims may be suitably combined in any manner apparent to one of ordinary skill in the art.

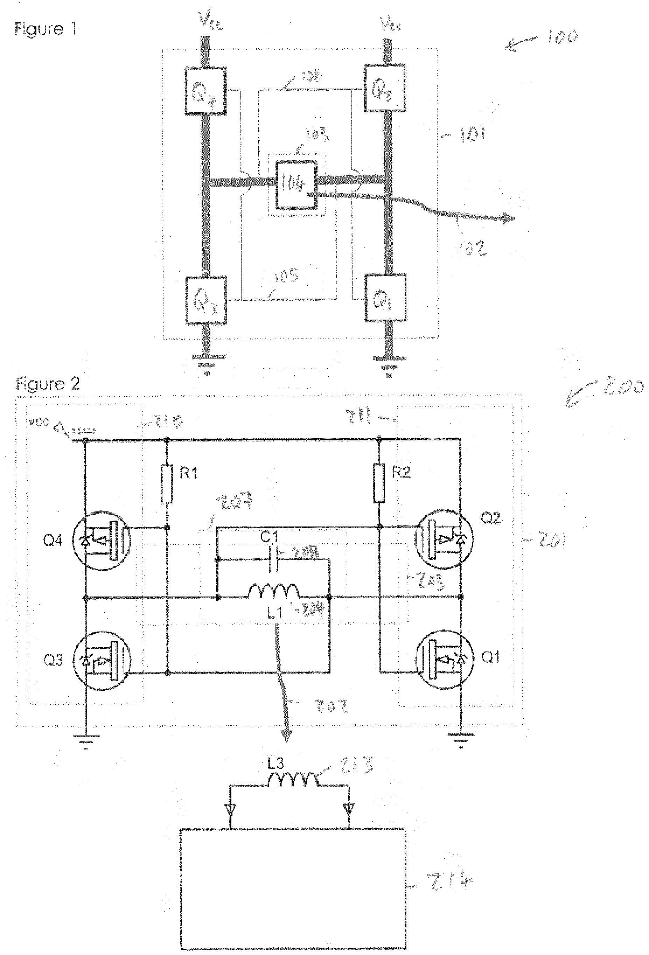

Figure 1 focuses on the functional components necessary for describing the operation of the apparatus. The component blocks of Figure 1 are functional and the functions described may or may not be performed by a single physical entity (such as is described with reference to Figure 2).

Figure 1 schematically illustrates a block diagram of an apparatus 100 comprising: means 101 configured to provide wireless power transmission 102 in a wireless power transmission mode, wherein the means 101 comprises an H bridge circuitry arrangement (the H bridge configuration is shown figuratively in thick outline) configured such that, in use during the wireless power transmission mode, the H bridge circuitry arrangement self-oscillates.

The H bridge circuitry arrangement 101 may comprise a plurality of switches Q1 - Q4 arranged in an H bridge configuration with a coil or inductor 104 in the bridged section 103 that generates the wireless power transmission signal 102.

An H bridge configuration is an electronic circuit configuration that can enable a voltage to be applied across a load, namely the coil 104 in this case, in either direction via appropriate arrangement of switches Q1 to Q4. For example, if Q4 and Q1 were both "ON" and Q2 and Q3 were both "OFF", a voltage on the left hand side of bridged section 103 would be +Vcc whereas a voltage on the right hand side of the bridged section 103 would be 0V / ground voltage. Thus a current would flow across the bridged section and the coil 104 towards the right hand side. Whereas, were both Q2 and Q3 to be "ON" and Q4 and Q1 to be "OFF", a current would flow across the coil 104 in the other direction towards the left hand side. Changing the switching state of the pairs of switches to and fro in this manner creates, from an input DC voltage +Vcc, an alternating current flowing through the coil which in turn generates an alternating/time varying magnetic field via which power can be wirelessly transferred to another (receiving) coil (not shown) via inductive coupling between the two coils, thereby providing near-field or non-radiative wireless power transmission.

The H bridge circuitry arrangement may receive an input DC voltage and be operable in two modes of operation, a first mode wherein a voltage is provided across the bridging section 103 (and thus the coil 104) at a first polarity and a second mode wherein a voltage is provided across the bridging section 103 (and thus the coil 104) in a second opposite polarity.

The H bridge circuitry arrangement 101 is configured such that, in use during the wireless power transmission mode, the H bridge circuitry arrangement self-oscillates, i.e. such that the polarity of the voltage applied across the bridged section 103 oscillates by itself and without the active control of a separate dedicated controller, e.g. processor/micro-controller, to actively control the switching states of the H bridge circuitry arrangement. Thus the direction of the current passing through the bridged section 103 and the coil 104 likewise also oscillates. The H bridge circuitry arrangement is configured such that such oscillation occurs by itself without requiring additional controlling hardware separate of the H bridge circuitry arrangement to control the voltage/current oscillation occurring within the H bridge circuitry arrangement.

In examples of the present disclosure, the H bridge circuitry arrangement 103 is utilised in the provision of the alternating current. In particular, the H bridge circuit arrangement is configured such that it can self-oscillate, i.e. automatically alternate between the two modes of operation without requiring external stimulus or external control separate of the H bridge circuit arrangement itself.

Previous wireless power transfer devices using an H bridge configuration required a separate dedicated controller to control the switching states of the switches in order to provide the alternating flow of direction of current, i.e. to control the switching and timing of the switching for each switch of the H bridge.

However, in examples of the present disclosure, the H-bridge circuit arrangement is configured such that it self oscillates, between switching states thereby providing the alternating current to the coil 104. Without limiting the scope of the claims, an advantage/technical effect of some examples of the present disclosure may be to avoid the need for a separate external component of the apparatus, e.g. a dedicated processor/controller separate of the H bridge circuitry, to actively control the switching states.

As will be discussed in further detail below, the self-oscillating configuration of the H-bridge circuit arrangement utilises a feedback loop. The coil 104 is arranged in a resonance circuit, i.e. connected in parallel to a capacitor, such that a voltage in the resonance circuit oscillates. The switches Q1-Q4 may be transistors, e.g. FET's, whose gates are coupled to the resonance circuit. For example, the gates of Q4 and Q3 are coupled to one side of the resonance circuit, as indicated by connecting line 105, and the gates of Q2 and Q1 are coupled to the other side of the resonance circuit, as indicated by connecting line 106. The resonance circuit's oscillating output creates an oscillating feedback drive signal to the gates of the transistors thereby controlling, and oscillating, the state of the transistors which provides an oscillating alternating current through the coil 104 at a particular constant frequency (which is determined by the values of the capacitor and inductor of the resonance circuit).

Figure 2 schematically illustrates a further apparatus 200 operating in a wireless power transmission mode to provide wireless power transmission 202. Means 201 for providing wireless power transmission comprises a resonance circuit 207 arranged within an H bridge circuitry arrangement. The H bridge circuitry arrangement comprises a plurality of transistors Q1 - Q4. The H bridge circuitry arrangement, and the biasing of its transistors, is configured such that, in use during the wireless power transmission mode, it self-oscillates.

The resonance circuit 207 comprises an inductor/coil 204 in parallel with a capacitor 208. The self-oscillation of the H bridge circuitry arrangement provides a self-oscillating alternating current within the resonance circuit which enables the generation of the wireless power transmission signal 202.

The resonance circuit 207 is coupled to each of the transistors Q1-Q4 so as to provide feedback to the transistors to control their switching state. The oscillating feedback from the resonance circuit oscillates the switching states of the transistors so as to direct an alternating current to the resonance circuit. In such a manner, a self-oscillating alternating current is provided to the resonance circuit.

The H bridge circuitry arrangement 203 broadly comprises two circuitry branches 210 and 211 comprising transistors Q4 + Q3 and Q2 + Q1 respectively, with a bridged section 203 therebetween comprising the resonance circuit 207.

The source of Q4 is connected to DC voltage Vcc and its drain is connected to both the source of Q3 and one side, a first side, of the resonance circuit 207. The drain of Q3 is connected to ground. The source of Q2 is connected to voltage Vcc and its drain is connected to both the source of Q1 and the other side, a second side, of the resonance circuit 207. The drain of Q3 is connected to ground.

The gates of Q4 and Q3 are connected to the second side of the resonance circuit (i.e. to one side of the capacitor's plates) whilst the gates of Q2 and Q1 are connected to the first side of the resonance circuit (i.e. the other side of the capacitor's plates).

The gates of Q4 and Q3 are also connected to Vcc via a resistor R1. Likewise, the gates of Q2 and Q1 are also connected to Vcc via a resistor R2. The resistors R1 and R2 are provided to provide an initial biasing of the transistors to facilitate starting the oscillation.

Q1 and Q2 may be configured/biased such that they cannot both be in a low impedance state at the same time. Similarly, Q3 and Q4 may be configured/biased such that they cannot both be in a low impedance state at the same time.

The voltage level between Q1 and Q2 drives Q3 and Q4 to their opposite states causing positive feedback and which sets up an oscillation of the H-bridge circuit arrangement, i.e. self-oscillation without requiring the active control of the switching states of the transistors. The switching states of the transistors are automatically changed due to feedback from the oscillating voltage between the capacitor 208 and inductor 204 of the resonance circuit. The frequency of the oscillation is determined by the values of the inductance of inductor 204 and capacitance of capacitor 208.

The oscillating current through the inductor 204 generates an alternating magnetic field. Another inductor 213 of a separate device 214 is inductively coupled to the inductor 204. The inductor 213 induces a voltage which can be used to power the device 214 or charge a battery of the device (not shown).

In this example the transistors Q2 and Q4 are p channel MOSFET depletion transistors whereas transistors Q1 and Q3 are n channel MOSFET depletion transistors. However, it will be appreciated that examples of the present disclosure could be duly modified to utilise other types of transistors or electrical switches, with an appropriate biasing and interconnection/configuration so as to provide the above described self-oscillating H bridge circuitry arrangement.

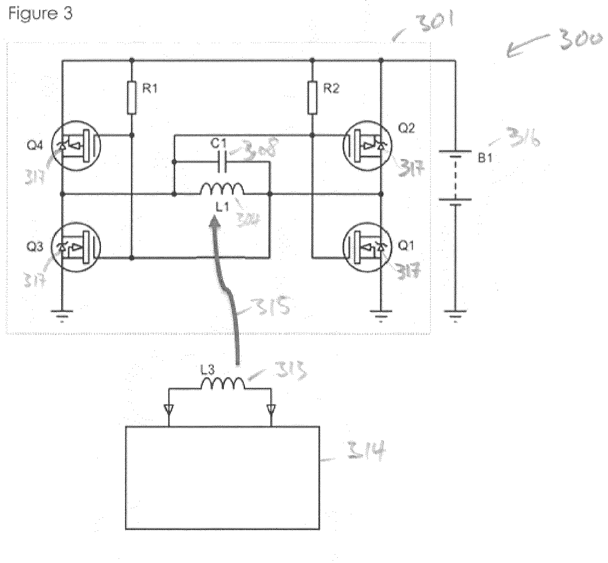

Figure 3 schematically illustrates a yet further apparatus 300 operating in a wireless power reception mode. The apparatus broadly corresponds to the apparatus of Figure 2, except, instead of being powered by an external DC voltage source Vcc and operating as a wireless power transmitter, the apparatus 300 is operable as a wireless power receiver and is powered via a wireless power transmission signal 315, namely a time varying alternating magnetic field, received from an inductor 313 of a separate wireless power transmitting device 314.

The apparatus 300 comprises means 301 configured to provide wireless power reception which comprises an H bridge circuitry arrangement as set out above which comprises a plurality of transistors Q1-Q4 and a resonance circuit comprising an inductor/coil 304 and capacitor 308.

The H bridge circuitry arrangement is configured such that, in use during the wireless power receiving mode, it rectifies the wirelessly received alternating voltage induced in the inductor 304 and enables the rectified voltage to be supplied to a power storage module 316, e.g. battery or some other voltage source/storage, to charge the same.

In the wireless reception mode, induced alternating current drives the transistors to a low impedance state allowing current to flow to the battery. The H bridge circuitry arrangement may comprise a plurality of diodes 317 that are configured and arranged so as to rectify the wirelessly received alternating voltage to provide a rectified voltage output to the battery 316. The diodes 317 may be part of transistors Q1 - Q4 or may be separate components provided in the branches of the H bridge.

When an alternating voltage induced by the inductor/coil 304 in the wireless reception mode is positive on the right-hand side of the resonance circuit, the diodes inside Q3 and Q2 allow an induced current to flow to be passed onto the battery 316. When the induced voltage gets high enough, Q3 and Q2 switch to a low impedance state as their respective gate voltages also get correspondingly higher causing a significantly reduced voltage drop. Likewise, when an alternating voltage induced by conductor 304 in the wireless reception mode is positive on the left-hand side of the resonance circuit, the diodes inside Q1 and Q4 allow an induced current to flow to be passed onto the battery 316. When the induced voltage gets high enough, Q1 and Q4 switch to a low impedance state as their respective gate voltages also get correspondingly higher causing a significantly reduced voltage drop

The apparatus 300 may provide high levels of efficiency in use since the self-oscillation of the H bridge circuitry arrangement generates a drive signal to control the transistor states in a synchronous manner. When the frequency of the input wireless power transmission signal 315 is close enough to the resonance frequency of the resonance circuit, the synchronous rectifier drive signal is amplified. In some examples, when the input frequency of the input wireless power transmission signal 315 is correctly selected (e.g. having a frequency lower that the resonance of the inductor/coil 304 and capacitor 308) the resultant self-oscillation of the H-bridge circuitry arrangement causes the switches Q1-Q4 to close pre-emptively, even before an input voltage is able to drive the switches to an on state.

The H bridge circuitry arrangement not only provides a push pull output for the coil 304 during a wireless power transmission mode of operation but also provides full bridge rectification of an induced voltage during a wireless power reception mode of operation.

Without limiting the scope of the claims, an advantage/technical effect of some examples of the present disclosure is that the same H-bridge circuitry arrangement can be used for both wireless power transmission as well as a wireless power reception thereby avoiding the need for separate dedicated circuitry (as well as associated dedicated controller to control the same) to function in each mode of operation.

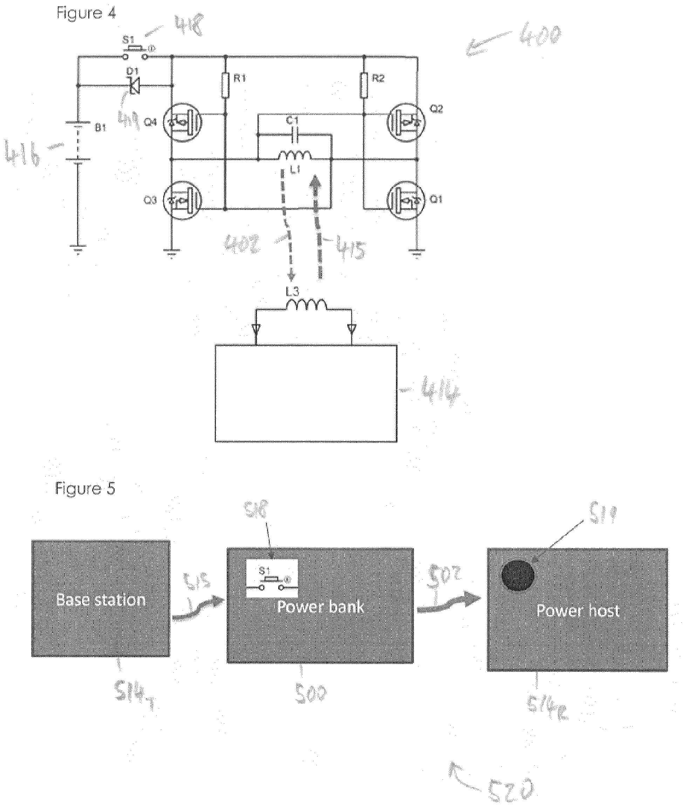

Figure 4 schematically illustrates a yet further apparatus 400 broadly similar to a combination of the apparatuses 200 and 300. The apparatus 400 is operable in a wireless power transmission mode, whereby it generates a wirelesses power transmission signal 402 to wirelessly transfer power to a separate device 414. The apparatus is also operable in a wireless power reception mode, whereby it receives a wirelesses power transmission signal 415 from a separate device 414.

The apparatus comprises means 418, such as a switch, for selectively coupling a voltage source 416 to the H bridge circuitry arrangement. When the switch is closed, this starts the self-oscillation of the H bridge circuitry arrangement for operating in a wireless power transmission mode. The voltage source 416 is additionally coupled to the H-bridge circuit arrangement via means, such as a diode 419, which is configured so as to prevent the flow of current therethrough from the voltage source to the H bridge, but to enable the flow of current from the H bridge to the voltage source, i.e. so as to enable charging up of the voltage source during operation as a wireless power receiver.

Although the various above described apparatuses 100, 200, 300 and 400 have been described with reference to Field Effect Transistors (FET's), it will be appreciated that other types of transistors could be used being appropriately configured, i.e. appropriately biased and arranged/connected in the H bridge circuitry arrangement, so as to provide the above described self-oscillation.

The above described apparatuses may be provided in a module. As used here 'module' refers to a unit or apparatus that excludes certain parts/components that would be added by an end manufacturer or a user.

The above described apparatuses may be comprised in a device that is configured for at least one of: wireless communication, mobile telephony, portable use, handheld use and wearable use. Such a device being configured to wirelessly transmit and/or wirelessly receive power using the above described apparatuses. Devices incorporating the apparatuses may have additional functionality e.g. not least for example: wireless communication and media playback.

In certain examples, the apparatuses may be embodied on a hand held portable electronic device, such as a mobile telephone, wearable computing device or personal digital assistant, that may additionally provide one or more audio/text/video communication functions (e.g. telecommunication, video-communication, and/or text transmission (Short Message Service (SMS)/ Multimedia Message Service (MMS)/emailing) functions), interactive/non-interactive viewing functions (e.g. web-browsing, navigation, TV/program viewing functions), music recording/playing functions (e.g. Moving Picture Experts Group-1 Audio Layer 3 (MP3) or other format and/or (frequency modulation/amplitude modulation) radio broadcast recording/playing), downloading/sending of data functions, image capture function (e.g. using a (e.g. in-built) digital camera), and gaming functions.

Although examples of the apparatus have been described above in terms of comprising various components, it should be understood that each of the components may be one or more of any device, means or circuitry that is configured to perform the corresponding functions of the respective components as described above.

Figure 5 schematically illustrates a wireless power transfer system 520 comprising various separate devices, namely:
a wireless power transmitter device 514_{T}, referred to as Base station (i.e. similar to device 314)
a combined wireless power transmitter and receiver device 500 (i.e. similar to apparatus 400), referred to as Power Bank and
a wireless power receiver device 514_{R}, referred to as Power host (i.e. similar to device 214).

The apparatus 100, 200, 300 and 400 may be used in each of the devices 514_{T}, 500 and 514_{R}.

The wireless power transmitter device 514_{T}, generates a wireless power transmission signal 515 which is received by the combined wireless power transmitter and receiver device 500, e.g. for its own consumption or to charge its own on board power source, e.g. battery.

Once charged, the combined wireless power transmitter and receiver device 500 can be used to generate a wireless power transmission signal 502 that is received by the wireless power receiver device 514_{R} for its own consumption, i.e. to power the device 514_{R} or to charge an on board power source.

The combined wireless power transmitter and receiver device 500 comprises a means 518 for selectively coupling a voltage source 416 to the H bridge circuitry arrangement upon detection of the wireless power receiving device 514_{R}, i.e. upon determination that the apparatus 500 is to operate in a wireless power transmission mode. For example, the means 518 may comprise a reed relay switch which is magnetically activatible when in proximity to a magnet 519 of the wireless power receiving device. The reed relay switch of the apparatus 500 and the magnet 519 of the device 514_{R} may each be respectively positioned such that, when the apparatus and device 514_{R} brought together to effect charging of the device 514_{R}, the reed relay switch and magnet are substantially co-located such that they are proximal to one another. For example, the apparatus 500 may take the form of a cradle or other receptacle for receiving the device 514_{R}. When the reed relay switch is activated/ "ON" the apparatus can operate in a wireless power transmission mode, otherwise, when the reed relay switch is "OFF" the apparatus can operate in a wireless power reception mode.

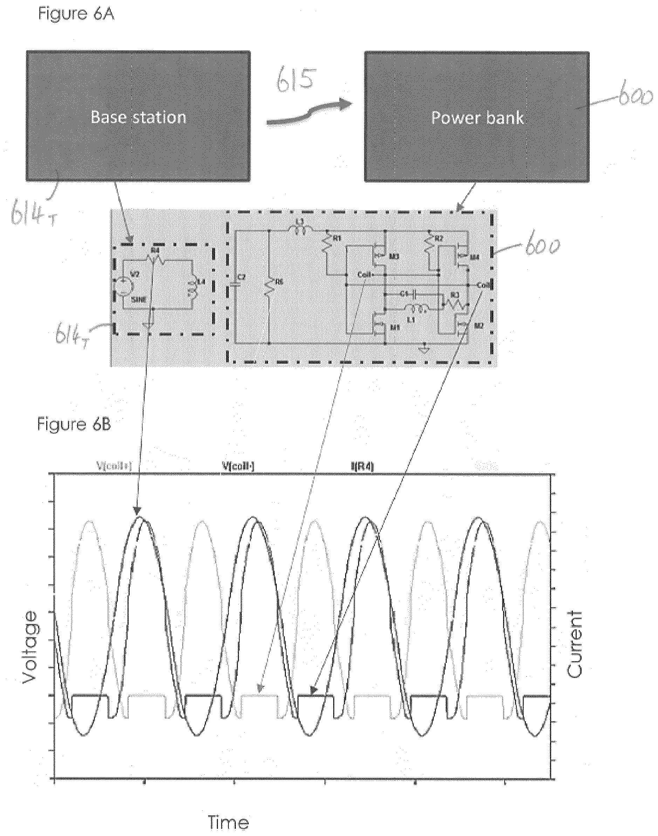

Figure 6A schematically illustrates a wireless power transmitter device 614_{T} and a combined wireless power transmitter and receiver device 600 as well as a circuit diagrams for the same.

The wireless power transmitter device 614_{T} generates a wireless power transmission signal 615 which provides inductive AC energy to the combined wireless power transmitter and receiver device 600.

In the circuit diagrams, certain extra components, e.g. L3, R6, C2 are shown which are provided for the modelling purposes only in relation to the simulated voltage and current measurements that are shown in Figure 6B.

The I(R6) curve of Figure 6B simulates the rectified voltage received by the combined wireless power transmitter and receiver device 600 that can be consumed by the device itself (i.e. power other components of the device) or used to charge an on-board voltage source/battery (not shown) when the device 600 is operating in an wireless power reception mode.

The block shaped bottom sections of the V(coil+) and V coil(-) curves relate to the switching on and off of the transistors.

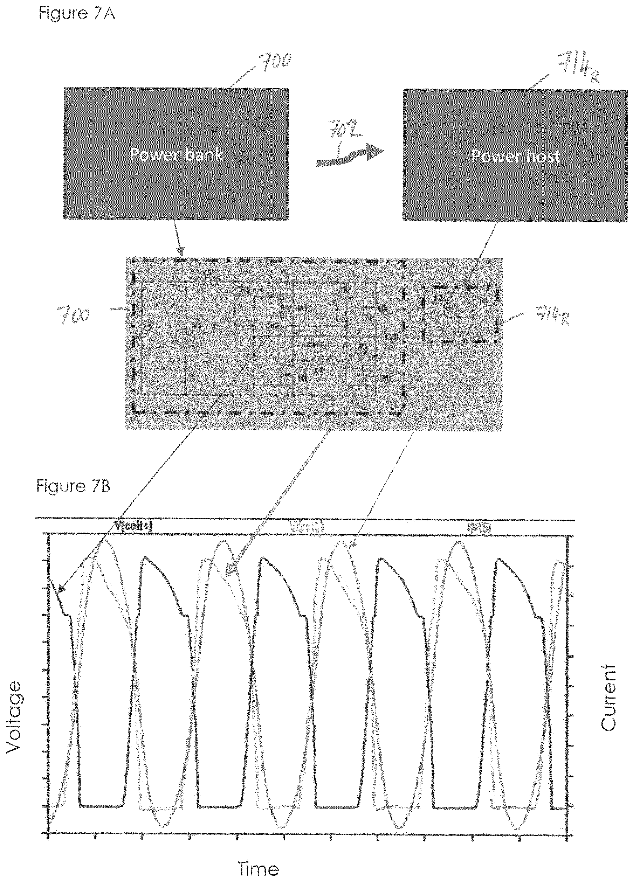

Figure 7A schematically illustrates a combined wireless power transmitter and receiver device 700 and a wireless power receiver device 714_{R} as well as a circuit diagrams for the same.

The combined wireless power transmitter and receiver device 700 generates a wireless power transmission signal 702 which provides inductive AC energy to the wireless power receiver device 714_{R}. The combined wireless power transmitter and receiver device 700 is itself powered by on-board voltage source V1.

In the circuit diagrams, certain extra components, e.g. L3, C2, are shown which are provided for the modelling purposes only in relation to the simulated voltage and current measurements that are shown in Figure 7B.

The I(R5) curve of Figure 7B simulates the voltage received and induced by the wireless power receiver device 714_{R} for consumption by the device itself (i.e. power other components of the device or used to charge an on-board voltage source/battery [not shown]) when the device 700 is operating in a wireless power transmission mode.

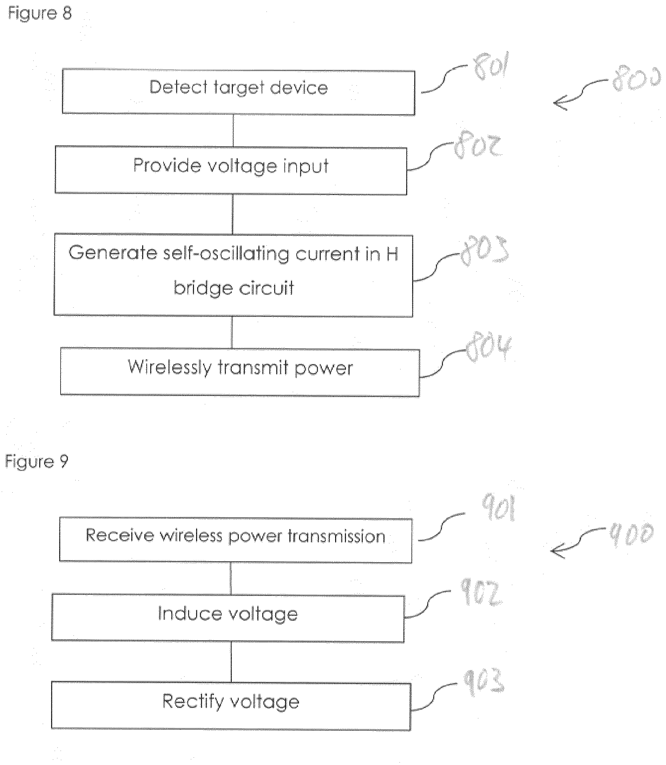

Figure 8 schematically illustrates a flow chart of a method 800 for wireless power transmission using the above described apparatuses. In block 801, a target device, e.g. wireless power receiving device such as 514_{R}, is detected. This can be achieved, for example, via the reed relay and magnet configuration as described above with respect to Figure 5. In response to such detection, in block 802 a voltage input is provided to the apparatus, e.g. apparatus 500. In block 803, a self-oscillating current is generated in the H bridge circuitry arrangement of the apparatus 500. This may be achieved by using feedback from a resonance circuit of the apparatus to control a switching state of the electrical switches H bridge circuitry arrangement so as to provide a self-oscillating alternating current within the resonance circuit and the coil.

In block 804, wireless power is transmitted, i.e. due to the self-oscillating current passing back and forth through the coil of resonance circuit of the apparatus thereby generating time varying alternating magnetic field which can convey electrical power via inductive coupling with a further coil of the wireless power receiving device, e.g. device 514_{R}.

Figure 9 schematically illustrates a flow chart of a further method 900 for wireless power reception using the above described apparatuses. In block 901, a wireless power transmission signal is received, e.g. wireless power transmission signal 515. In block 902, a voltage is induced, i.e. via a coil of the apparatus 500 due to the received wireless power transmission signal. In block 903, the induced voltage is rectified via the H bridge circuitry arrangement. The rectified voltage may then be consumed, e.g. by providing power to other components / parts of the apparatus or by charging a power source of the apparatus, e.g. an on-board battery.

The flowchart of each of Figures 8 and 9 represent one possible scenario among others. Not all the blocks are essential. In certain examples one or more blocks may be performed in a different order or overlapping in time, in series or in parallel. One or more blocks may be omitted or added or changed in some combination of ways.

Examples of the present disclosure provide both a method and corresponding apparatus comprising various modules, means or circuitry that provide the functionality for performing the actions of the method.

The apparatus may be provided in an electronic device, for example, mobile terminal, according to an exemplary embodiment of the present disclosure. It should be understood, however, that a mobile terminal is merely illustrative of an electronic device that would benefit from examples of implementations of the present disclosure and, therefore, should not be taken to limit the scope of the present disclosure to the same. While certain in certain implementation examples the apparatus may be provided in a mobile terminal, other types of electronic devices, such as, but not limited to, hand portable electronic devices, wearable computing devices, portable digital assistants (PDAs), pagers, mobile computers, desktop computers, televisions, gaming devices, laptop computers, cameras, video recorders, GPS devices and other types of electronic systems, may readily employ examples of the present disclosure. Furthermore, devices may readily employ examples of the present disclosure regardless of their intent to provide mobility.

Features described in the preceding description may be used in combinations other than the combinations explicitly described.

Although functions have been described with reference to certain features, those functions may be performable by other features whether described or not. Although features have been described with reference to certain examples, those features may also be present in other examples whether described or not. Although various examples of the present disclosure have been described in the preceding paragraphs, it should be appreciated that modifications to the examples given can be made without departing from the scope of the invention as set out in the claims.

The term 'comprise' is used in this document with an inclusive not an exclusive meaning. That is any reference to X comprising Y indicates that X may comprise only one Y or may comprise more than one Y. If it is intended to use 'comprise' with an exclusive meaning then it will be made clear in the context by referring to "comprising only one ..." or by using "consisting".

In this description, the wording 'connect', 'couple' and 'communication' and their derivatives mean operationally connected/coupled/in communication. It should be appreciated that any number or combination of intervening components can exist (including no intervening components).

In this description, reference has been made to various examples. The description of features or functions in relation to an example indicates that those features or functions are present in that example. The use of the term 'example' or 'for example' or 'may' in the text denotes, whether explicitly stated or not, that such features or functions are present in at least the described example, whether described as an example or not, and that they can be, but are not necessarily, present in some or all other examples. Thus 'example', 'for example' or 'may' refers to a particular instance in a class of examples. A property of the instance can be a property of only that instance or a property of the class or a property of a sub-class of the class that includes some but not all of the instances in the class.

In this description, references to "a/an/the" [feature, element, component, means ...] are to be interpreted as "at least one" [feature, element, component, means ...] unless explicitly stated otherwise.

The above description describes some examples of the present disclosure however those of ordinary skill in the art will be aware of possible alternative structures and method features which offer equivalent functionality to the specific examples of such structures and features described herein above and which for the sake of brevity and clarity have been omitted from the above description. Nonetheless, the above description should be read as implicitly including reference to such alternative structures and method features which provide equivalent functionality unless such alternative structures or method features are explicitly excluded in the above description of the examples of the present disclosure.

Whilst endeavouring in the foregoing specification to draw attention to those features of examples of the present disclosure believed to be of particular importance it should be understood that the applicant claims protection in respect of the combination of features defined in the independent claims whether or not particular emphasis has been placed thereon.

## Claims

1. An apparatus (200) comprising:
means (201) configured to provide wireless power transmission (202) in a wireless power transmission mode, wherein the means (201) comprises an H bridge circuitry arrangement (203, 210, 211) configured such that, in use during the wireless power transmission mode, the H bridge circuitry arrangement (203, 210, 211) self-oscillates; wherein the H bridge circuitry arrangement (203, 210, 211) comprises a resonance circuit (207) comprising an inductor (204) arranged in parallel with a capacitor (208);
wherein the H bridge circuitry arrangement (203, 210, 211) comprises:
a first circuit branch (210),
a second circuit branch (211), and
a bridged section (203), between the first and second branches, which comprises the resonance circuit (207);
wherein the second circuit branch (211) comprises first and second transistors (Q1, Q2) whose gates are coupled to one side of the resonance circuit (207) that is connected to a node between third and forth transistors (Q3, Q4) of the first circuit branch (210), and wherein the first circuit branch (210) comprises the third and
fourth transistors (Q3, Q4) whose gates are coupled to another side of the resonance circuit (207) that is connected to a node between the first and second transistors (Q1, Q2) of the second circuit branch (211);
the apparatus further comprising means configured to provide wireless power reception in a wireless power receiving mode, wherein such means comprises the H bridge circuitry arrangement (203, 210, 211), and wherein the H bridge circuitry arrangement (203, 210, 211) is configured to rectify an induced alternating voltage;
the apparatus further comprising a voltage source (416), first means (418) and second means (416), wherein the first means (418) is configured to selectively couple the voltage source (416) to the H bridge circuitry arrangement so that, when the H bridge is coupled to the voltage source, the self-oscillation of the H bridge circuitry arrangement is started for operating in the wireless power transmission mode; and
wherein the voltage source (416) is additionally coupled to the H bridge circuit arrangement via the second means (419) configured so as to prevent the flow of current therethrough from the voltage source to the H bridge, whilst enabling the flow of current from the H bridge to the voltage source so as to enable charging up of the voltage source during operation in the wireless power receiving mode.

2. The apparatus (200) of claim 1, wherein the resonance circuit (207) is coupled to the transistors to provide feedback to the transistors to control the state of the transistors such that, in the wireless power transmission mode, an alternating current flows through the H bridge circuitry arrangement (203, 210, 211).

3. The apparatus (200) of claim 2, wherein the H bridge circuitry arrangement (203, 210, 211) comprises a plurality of diodes (317) configured to rectify the induced alternating voltage.

4. The apparatus (200) of any one of the previous claims, wherein the voltage source (416) is configured to provide power for the apparatus (200) when operating in the wireless power transmission mode; and the voltage source (416) is configured to receive power when operating in the wireless power reception mode.

5. The apparatus (200) of claim 4, further configured to operate in the wireless power transmission mode upon detection of a device (514_{R}) for receiving the wireless power transmission.

6. A module comprising the apparatus (200) of any one of the previous claims.

7. A device (500) configured to wirelessly transmit and/or wirelessly receive power comprising the apparatus (200) as claimed in any one of claims 1 to 5, or the module of claim 6.

8. The device of claim 7, wherein the device is configured for at least one of:
wireless communication, mobile telephony, portable use, handheld use and wearable use.

9. A system (520) comprising:
the apparatus (200) as claimed in any one of claims 1 to 5; and
one or more of:
a device (514_{R}), separate of the apparatus (200), for receiving wireless power transmission signals (502) generated by the apparatus (200); and
a device (514_{T}), separate of the apparatus (200), for generating wireless power transmission signals (515) for reception by the apparatus (200).

10. A method comprising:
providing the apparatus (200) of any one of claims 1 to 5;
generating a self-oscillating current in the H bridge circuitry arrangement (203, 210, 211) of the apparatus (200); and
wirelessly transmitting power (502) via the H bridge circuitry arrangement (203, 210, 211).

11. The method of claim 10, further comprising providing a voltage input to the H bridge circuitry arrangement (203, 210, 211) in response to detecting a target device (514_{R}) for receipt of the wireless power transmission (502).

12. The method of claim 10 or 11, wherein the H bridge circuitry arrangement (203, 210, 211) comprises the resonance circuit (207) for providing the wireless power transmission, the method further comprising:
using feedback from the resonance circuit (207) to control the state of the H bridge circuitry arrangement (203, 210, 211) to provide a self-oscillating alternating current within the resonance circuit (207).

13. The method of claim 10, 11 or 12, further comprising causing, at least in part, actions that result in:
receiving a wireless power transmission (515);
inducing a voltage from the received wireless power transmission (515); and
rectifying the induced voltage via the H bridge circuitry arrangement (203, 210, 211).

## Patentansprüche

1. Vorrichtung (200), umfassend:
eine Einrichtung (201), die dazu ausgelegt ist, eine drahtlose Stromübertragung (202) in einem drahtlosen Stromübertragungsmodus bereitzustellen, wobei die Einrichtung (201) eine H-Brückenschaltungsanordnung (203, 210, 211) umfasst, die so ausgelegt ist, dass bei Verwendung während des drahtlosen Stromübertragungsmodus die H-Brückenschaltungsanordnung (203, 210, 211) selbstschwingend ist;
wobei die H-Brückenschaltungsanordnung (203, 210, 211) einen Resonanzkreis (207) mit einer parallel zu einem Kondensator (208) angeordneten Induktivität (204) umfasst;
wobei die H-Brückenschaltungsanordnung (203, 210, 211) umfasst:
einen ersten Schaltungszweig (210),
einen zweiten Schaltungszweig (211) und
einen überbrückten Abschnitt (203) zwischen dem ersten und dem zweiten Zweig, der den Resonanzkreis (207) umfasst;
wobei der zweite Schaltungszweig (211) einen ersten und einen zweiten Transistor (Q1, Q2) umfasst, deren Gates mit einer Seite des Resonanzkreises (207) gekoppelt sind, der mit einem Knotenpunkt zwischen einem dritten und einem vierten Transistor (Q3, Q4) des ersten Schaltungszweigs (210) verbunden ist, und wobei der erste Schaltungszweig (210) den dritten und den vierten Transistor (Q3, Q4) umfasst, deren Gates mit einer anderen Seite des Resonanzkreises (207) gekoppelt sind, der mit einem Knotenpunkt zwischen dem ersten und dem zweiten Transistor (Q1, Q2) des zweiten Schaltungszweigs (211) verbunden ist;
wobei die Vorrichtung ferner eine Einrichtung umfasst, die dazu ausgelegt ist, drahtlosen Stromempfang in einem drahtlosen Stromempfangsmodus bereitzustellen, wobei eine solche Einrichtung die H-Brückenschaltungsanordnung (203, 210, 211) umfasst, und wobei die H-Brückenschaltungsanordnung (203, 210, 211) dazu ausgelegt ist, eine induzierte Wechselspannung gleichzurichten;
wobei die Vorrichtung ferner eine Spannungsquelle (416), eine erste Einrichtung (418) und eine zweite Einrichtung (416) umfasst, wobei die erste Einrichtung (418) dazu ausgelegt ist, die Spannungsquelle (416) selektiv mit der H-Brückenschaltungsanordnung zu koppeln, sodass, wenn die H-Brücke mit der Spannungsquelle gekoppelt ist, die Selbstschwingung der H-Brückenschaltungsanordnung zum Betreiben im drahtlosen Stromübertragungsmodus gestartet wird; und
wobei die Spannungsquelle (416) zusätzlich mit der H-Brückenschaltungsanordnung über die zweite Einrichtung (419) gekoppelt ist, die dazu ausgelegt ist, den Stromfluss durch diese von der Spannungsquelle zur H-Brücke zu verhindern, während der Stromfluss von der H-Brücke zur Spannungsquelle ermöglicht wird, um das Aufladen der Spannungsquelle während des Betriebs im drahtlosen Stromempfangsmodus zu ermöglichen.

2. Vorrichtung (200) nach Anspruch 1, wobei der Resonanzkreis (207) mit den Transistoren gekoppelt ist, um eine Rückkopplung an die Transistoren zu liefern, um den Zustand der Transistoren so zu steuern, dass im drahtlosen Stromübertragungsmodus ein Wechselstrom durch die H-Brückenschaltungsanordnung (203, 210, 211) fließt.

3. Vorrichtung (200) nach Anspruch 2, wobei die H-Brückenschaltungsanordnung (203, 210, 211) eine Vielzahl von Dioden (317) umfasst, die dazu ausgelegt sind, die induzierte Wechselspannung gleichzurichten.

4. Vorrichtung (200) nach einem der vorhergehenden Ansprüche, wobei die Spannungsquelle (416) dazu ausgelegt ist, beim Betrieb im drahtlosen Stromübertragungsmodus Strom für die Vorrichtung (200) zu liefern; und
die Spannungsquelle (416) dazu ausgelegt ist, beim Betrieb im drahtlosen Stromempfangsmodus Strom zu empfangen.

5. Vorrichtung (200) nach Anspruch 4, ferner dazu ausgelegt, bei Erkennung eines Geräts (514_{R}) zum Empfangen der drahtlosen Stromübertragung im drahtlosen Stromübertragungsmodus zu arbeiten.

6. Modul, umfassend die Vorrichtung (200) nach einem der vorhergehenden Ansprüche.

7. Gerät (500), das dazu ausgelegt ist, drahtlos Strom zu übertragen und/oder drahtlos Strom zu empfangen, umfassend die Vorrichtung (200) nach einem der Ansprüche 1 bis 5 oder das Modul nach Anspruch 6.

8. Gerät nach Anspruch 7, wobei das Gerät für mindestens eines von Folgendem ausgelegt ist:
drahtlose Kommunikation, Mobiltelefonie, portable Nutzung, handgeführte Nutzung und am Körper tragbare Nutzung.

9. System (520), umfassend:
die Vorrichtung (200) nach einem der Ansprüche 1 bis 5; und einem oder mehreren von:
einem von der Vorrichtung (200) getrennten Gerät (514_{R}) zum Empfangen von durch die Vorrichtung (200) erzeugten drahtlosen Stromübertragungssignalen (502); und
einem von der Vorrichtung (200) getrennten Gerät (514_{T}) zum Erzeugen von drahtlosen Stromübertragungssignalen (515) zum Empfang durch die Vorrichtung (200).

10. Verfahren, umfassend:
Bereitstellen der Vorrichtung (200) nach einem der Ansprüche 1 bis 5;
Erzeugen eines selbstschwingenden Stroms in der H-Brückenschaltungsanordnung (203, 210, 211) der Vorrichtung (200); und
drahtlose Stromübertragung (502) über die H-Brückenschaltungsanordnung (203, 210, 211).

11. Verfahren nach Anspruch 10, ferner umfassend das Bereitstellen eines Spannungseingangs an die H-Brückenschaltungsanordnung (203, 210, 211) als Reaktion auf das Erkennen eines Zielgeräts (514_{R}) für den Empfang der drahtlosen Stromübertragung (502).

12. Verfahren nach Anspruch 10 oder 11, wobei die H-Brückenschaltungsanordnung (203, 210, 211) den Resonanzkreis (207) zum Bereitstellen der drahtlosen Stromübertragung umfasst, wobei das Verfahren ferner umfasst:
Verwenden von Rückkopplung aus dem Resonanzkreis (207), um den Zustand der H-Brückenschaltungsanordnung (203, 210, 211) zu steuern, um einen selbstschwingenden Wechselstrom innerhalb des Resonanzkreises (207) bereitzustellen.

13. Verfahren nach Anspruch 10, 11 oder 12, ferner umfassend das mindestens teilweise Bewirken von Handlungen, die zu Folgendem führen:
Empfangen einer drahtlosen Stromübertragung (515);
Induzieren einer Spannung aus der empfangenen drahtlosen Stromübertragung (515); und
Gleichrichten der induzierten Spannung über die H-Brückenschaltungsanordnung (203, 210, 211).

## Revendications

1. Appareil (200) comprenant :
un moyen (201) configuré pour assurer une émission de puissance sans fil (202) dans un mode d'émission de puissance sans fil, le moyen (201) comprenant un agencement de circuiterie de pont en H (203, 210, 211) configuré de sorte que, lors de l'utilisation pendant le mode d'émission de puissance sans fil, l'agencement de circuiterie de pont en H (203, 210, 211) auto-oscille ; l'agencement de circuiterie de pont en H (203, 210, 211) comprenant un circuit de résonance (207) comprenant une bobine d'induction (204) agencée parallèlement à un condensateur (208) ;
l'agencement de circuiterie de pont en H (203, 210, 211) comprenant :
une première branche de circuit (210),
une seconde branche de circuit (211), et
une section pontée (203), entre les première et seconde branches, qui comprend le circuit de résonance (207) ;
la seconde branche de circuit (211) comprenant des premier et deuxième transistors (Q1, Q2) dont les grilles sont couplées à un côté du circuit de résonance (207) qui est connecté à un nœud entre des troisième et quatrième transistors (Q3, Q4) de la première branche de circuit (210), et la première branche de circuit (210) comprenant les troisième et quatrième transistors (Q3, Q4) dont les grilles sont couplées à un autre côté du circuit de résonance (207) qui est connecté à un nœud entre les premier et deuxième transistors (Q1, Q2) de la seconde branche de circuit (211) ;
l'appareil comprenant en outre un moyen configuré pour assurer une réception de puissance sans fil dans un mode de réception de puissance sans fil, ledit moyen comprenant l'agencement de circuiterie de pont en H (203, 210, 211) et l'agencement de circuiterie de pont en H (203, 210, 211) étant configuré pour redresser une tension alternative induite ;
l'appareil comprenant en outre une source de tension (416), un premier moyen (418) et un second moyen (416), le premier moyen (418) étant configuré pour coupler de manière sélective la source de tension (416) à l'agencement de circuiterie de pont en H de sorte que, quand le pont en H est couplé à la source de tension, l'auto-oscillation de l'agencement de circuiterie de pont en H démarre pour fonctionner dans le mode d'émission de puissance sans fil ; et
la source de tension (416) étant en outre couplée à l'agencement de circuiterie de pont en H par l'intermédiaire du second moyen (419) configuré de manière à y empêcher la circulation de courant de la source de tension au pont en H, tout en permettant la circulation de courant du pont en H à la source de tension de manière à permettre la recharge de la source de tension pendant le fonctionnement dans le mode de réception de puissance sans fil.

2. Appareil (200) selon la revendication 1, dans lequel le circuit de résonance (207) est couplé aux transistors pour fournir un retour aux transistors pour contrôler l'état des transistors de sorte que, dans le mode d'émission de puissance sans fil, un courant alternatif circule à travers l'agencement de circuiterie de pont en H (203, 210, 211).

3. Appareil (200) selon la revendication 2, dans lequel l'agencement de circuiterie de pont en H (203, 210, 211) comprend une pluralité de diodes (317) configurées pour redresser la tension alternative induite.

4. Appareil (200) selon l'une quelconque des revendications précédentes, dans lequel :
la source de tension (416) est configurée pour fournir une puissance à l'appareil (200) lors d'un fonctionnement dans le mode d'émission de puissance sans fil ; et
la source de tension (416) est configurée pour recevoir une puissance lors d'un fonctionnement dans le mode de réception de puissance sans fil.

5. Appareil (200) selon la revendication 4, configuré en outre pour fonctionner dans le mode d'émission de puissance sans fil à la détection d'un dispositif (514_{R}) pour recevoir l'émission de puissance sans fil.

6. Module comprenant l'appareil (200) selon l'une quelconque des revendications précédentes.

7. Dispositif (500), configuré pour émettre sans fil et/ou recevoir sans fil une puissance et comprenant l'appareil (200) selon l'une quelconque des revendications 1 à 5 ou le module selon la revendication 6.

8. Dispositif selon la revendication 7, le dispositif étant configuré pour au moins une des utilisations suivantes :
communication sans fil, téléphonie mobile, utilisation portable, utilisation de poche et utilisation mettable.

9. Système (520), comprenant :
l'appareil (200) selon l'une quelconque des revendications 1 à 5 ; et un ou plusieurs dispositifs parmi :
un dispositif (514_{R}), distinct de l'appareil (200), pour recevoir des signaux d'émission de puissance sans fil (502) générés par l'appareil (200) ; et
un dispositif (514_{T}), distinct de l'appareil (200), pour générer des signaux d'émission de puissance sans fil (515) destinés à être reçus par l'appareil (200).

10. Procédé comprenant les étapes consistant à :
fournir l'appareil (200) selon l'une quelconque des revendications 1 à 5 ;
générer un courant auto-oscillant dans l'agencement de circuiterie de pont en H (203, 210, 211) de l'appareil (200) ; et
émettre sans fil une puissance (502) par l'intermédiaire de l'agencement de circuiterie de pont en H (203, 210, 211).

11. Procédé selon la revendication 10, comprenant en outre l'étape consistant à fournir une entrée de tension à l'agencement de circuiterie de pont en H (203, 210, 211) en réponse à la détection d'un dispositif cible (514_{R}) pour recevoir l'émission de puissance sans fil (502) .

12. Procédé selon la revendication 10 ou 11, dans lequel l'agencement de circuiterie de pont en H (203, 210, 211) comprend le circuit de résonance (207) pour fournir l'émission de puissance sans fil, le procédé comprenant en outre l'étape consistant à :
utiliser un retour en provenance du circuit de résonance (207) pour contrôler l'état de l'agencement de circuiterie de pont en H (203, 210, 211) pour fournir un courant alternatif auto-oscillant dans le circuit de résonance (207).

13. Procédé selon la revendication 10, 11 ou 12, comprenant en outre l'étape consistant à provoquer, au moins en partie, des actions qui donnent lieu à :
la réception d'une émission de puissance sans fil (515) ;
l'induction d'une tension à partir de l'émission de puissance sans fil reçue (515) ; et
le redressement de la tension induite par l'intermédiaire de l'agencement de circuiterie de pont en H (203, 210, 211).
